# EUROPÄISCHE PATENTSCHRIFT

(11) **EP 0 584 622 B1**
(45) Veröffentlichungstag und Bekanntmachung des Hinweises auf die Patenterteilung: **01.05.1996**
(21) Anmeldenummer: 93112722.9
(22) Anmeldetag: 09.08.1993
(51) Int. Cl.: H02M 3/335, H02H 7/122, G05F 1/569

(54) **Durchflussumrichter mit RCD-Entlastungsnetzwerk**
Flow inverter with RCD-discharge circuit
Convertisseur du flux avec un circuit de décharge de type RCD

(30) Priorität: 28.08.1992 DE 4228763
(43) Veröffentlichungstag der Anmeldung: 02.03.1994
(73) Patentinhaber: SIEMENS AKTIENGESELLSCHAFT, D-80333 München (DE)
(72) Erfinder: Nonnenmacher, Ulrich, D-82131 Gauting (DE); Wagner, Franz, D-81377 München (DE)

(56) Entgegenhaltungen:
- EP-A- 0 272 514
- WO-A-86/03902
- WO-A-91/16756
- WO-A-92/13384
- DE-A- 3 732 334
- DE-B- 2 724 741

## Beschreibung

Die Erfindung bezieht sich auf einen wie im Oberbegriff des Patentanspruchs 1 angegebenen Durchflußumrichter.

Ein derartiger Durchflußumrichter ist bereits aus der Druckschrift Schaltnetzteile, Konzepte Bauelemente Anwendungen von Walter Hirschmann und Alfred Hauenstein, Siemens AG, 1990, Seite 321 bekannt. Bei der bekannten Schutzschaltung liegt parallel zu dem zu schützenden Leistungsschalter eine Serienschaltung aus einem Kondensator und einer Diode, wobei parallel zur Diode ein Widerstand angeordnet ist (siehe auch DE-B-2 724 741).

Ein parallel zum Leistungsschalter angeordnetes RCD-Entlastungsnetzwerk schützt den betreffenden Leistungsschalter beim Ausschalten vor zu großen Schaltverlusten durch gleichzeitiges Auftreten von Strom und Spannung. Zugleich sorgt es für eine Verringerung der Flankensteilheit der am Schalter auftretenden Spannung und bedämpft überlagerte hochfrequente Einschwingvorgänge, was im Hinblick auf eine Funkentstörung von Vorteil ist. Andererseits entsteht beim Ausschalten des Lastschalters ein Serienschwingkreis, bestehend aus der Übertrager-Hauptinduktivität und dem Kondensator der Beschaltung. Dieser Schwingkreis bewirkt ein sinusförmiges Überschwingen der Spannung am Lastschalter. Das Entlastungsnetzwerk spielt daher auch bei der Abmagnetisierung des Leistungsübertragers eine wesentliche Rolle. Schließlich werden unzulässig hohe Spannungsspitzen am Schalttransistor unterdrückt, die durch das schnelle Abschalten des Stromes in Folge von Leitungsinduktivität und Streuinduktivitäten des Leistungsübertragers entstehen könnten.

Das RCD-Entlastungsnetzwerk hat somit eine Reihe von Vorteilen. Allerdings wird beim Wiedereinschalten des Schalttransistors die im Kondensator gespeicherte Energie in Verlustwärme überführt und der Leistungsschalter muß den Entladestrom zusätzlich führen. Außerdem wird beim Überschwingen der Kondensatorspannung in der Sperrphase und bei der damit erfolgenden Ummagnetisierung des Übertragers auch eine nicht zu vernachlässigende Menge an Energie in den oder die Ausgangskreise transformiert. Dies kann bei schwacher Belastung zu lückendem Betrieb oder z.B. bei EMK-geregelten Geräten im Leerlauf sogar zu einem unzulässigen Anstieg der Ausgangsspannung führen. Ein lückender Betrieb ist jedoch insbesondere bei Geräten mit mehreren Ausgangskreisen nicht ohne weiteres zu akzeptieren.

Um die genannten Nachteile zu vermeiden, kann man eine relativ große Vorlast vorsehen. Diese verschlechtert jedoch den Wirkungsgrad der Schaltung insbesondere bei vergleichsweise geringer Belastung erheblich und erwärmt das Gerät zusätzlich.

Aufgabe der Erfindung ist es, einen Durchflußumrichter zu schaffen, dessen Entlastungsnetzwerk bei stark schwankender Last des Durchflußumrichters hinsichtlich Wirksamkeit der Entlastung und Verlustleistung selbsttätig an den jeweiligen Belastungsfall angepaßt ist.

Gemäß der Erfindung wird der Durchflußumrichter zur Lösung der gestellten Aufgabe in der im kennzeichnenden Teil des Patentanspruchs 1 angegebenen Weise ausgebildet.

Ein derartiger Durchflußumrichter bietet in vorteilhafter Weise sowohl eine wirksame Entlastung des Leistungsschalters bei hoher Ausgangsleistung als auch einen hohen Wirkungsgrad bei vergleichsweise geringer Belastung des Durchflußumrichters.

Dieser Vorteil ist insbesondere bei der Stromversorgung von Einrichtungen der Nachrichten-Vermittlungstechnik von wesentlicher Bedeutung, bei denen Umrichter im Durchschnitt sehr gering belastet sind und dabei aus Erwärmungsgründen einen hohen Wirkungsgrad aufweisen sollen. Der Durchflußumrichter ist daher besonders zur verlustarmen Speisung von Vermittlungseinrichtungen geeignet, die zu Stoßzeiten eine vergleichsweise große Leistung benötigen, im Stand-by-Betrieb dagegen mit einer vergleichsweise geringen Leistung auskommen.

Vorteilhafte Ausgestaltungen und Weiterbildungen der Erfindung sind Gegenstand der Unteransprüche.

Die Erfindung wird anhand der in den Figuren dargestellten Ausführungsbeispiele näher erläutert.

Es zeigen
- Fig. 1: einen Durchflußumrichter mit leistungsabhängig umschaltbarer Kapazität eines Entlastungsnetzwerkes,
- Fig. 2: einen Durchflußumrichter nach Fig. 1 mit abgewandelter Umschaltung der Kapazität und
- Fig. 3: eine Anordnung zu einer mit der Eingangsspannung gewichteten Mittelwertbildung des eingangsseitigen Pulsstromes,
- Fig. 4: einen Durchflußumrichter mit Regelung der Ausgangsspannung durch unterlagerte Stromregelung und
- Fig. 5: eine abgewandelte Teilschaltung des Durchflußumrichters nach Fig. 4,
- Fig. 6: eine Steuerschaltung für die Teilschaltung nach Fig. 5 und
- Fig. 7: einen Durchflußumrichter mit zwei wahlweise aktivierbaren Entlastungsnetzwerken und mit umschaltbarer Kapazität.

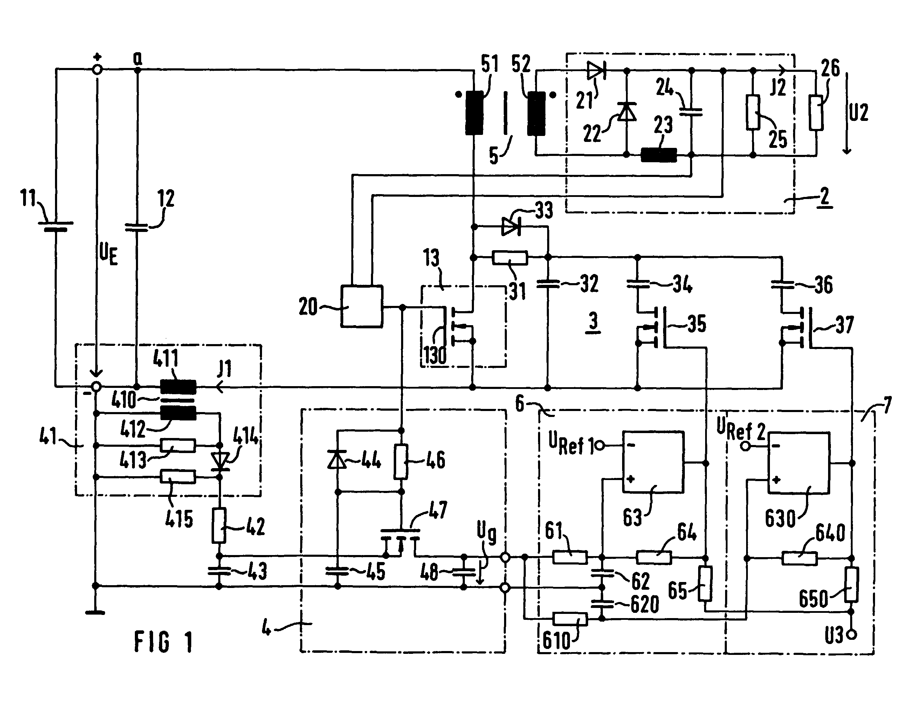

Fig. 1 zeigt einen Eintakt-Durchflußumrichter mit einem Leistungsschalter 13. Die von der Eingangsspannungsquelle 11 gelieferte Eingangsspannung U1 liegt am Kondensator 12, die Ausgangsspannung U2 am Kondensator 24. Parallel zum Kondensator 12 liegt in einem primärseitigen Hauptstromkreis eine aus der Primärwicklung 51 des Transformators 5, dem Leistungsschalter 13 und der Primärwicklung 411 des Stromwandlers 410 gebildete Serienschaltung. Der Leistungsschalter 13 ist mit seinem Steuereingang an die Steuerschaltung 20 angeschlossen, die taktgesteuert eine Folge von, insbesondere impulsdauermodulierten, Einschaltimpulsen abgibt.

Die Primärwicklung 51 des Transformators 5 wird daher über den Leistungsschalter 13 periodisch an die Gleichspannung der Eingangsspannungsquelle 11 gelegt. Als Schalttransistor für den Leistungsschalter 13 dient der Feldeffekttransistor 130.

Zwischen der Sekundärwicklung 52 des Transformators 5 und dem Kondensator 24 liegt die Gleichrichterdiode 21. In einem auf die Gleichrichterdiode 21 folgenden Querzweig ist die Freilaufdiode 22 angeordnet. In einem Längszweig zwischen Freilaufdiode 22 und Kondensator 24 liegt die Drossel 23. Parallel zum Kondensator 24 liegt der Widerstand 25. An der Parallelschaltung von Kondensator 24 und Widerstand 25 steht die Ausgangsspannung U2 für den Lastwiderstand 26 zur Verfügung. In den mit der Ausgangsspannung U2 gespeisten, einen Verbraucher bildenden Lastwiderstand 26 fließt der Ausgangsstrom I2.

Das aus dem Widerstand 31, dem Kondensator 32 und der Diode 33 bestehende Entlastungsnetzwerk sorgt für eine wirksame Ausschaltentlastung des Leistungsschalters 13. Das Entlastungsnetzwerk enthält eine aus der Diode 33 und dem Kondensator 32 bestehende Serienschaltung, die parallel zur Drain-Source- Strecke des den Leistungsschalter 13 bildenden Feldeffekttransistors angeordnet ist. Parallel zur Diode 33 der Serienschaltung liegt der Widerstand 31. Die Diode 33 ist in bezug auf die Eingangsspannung U1 in Durchlaßrichtung gepolt.

Parallel zum Kondensator 32 liegen mehrere Stromzweige, die jeweils aus einem weiteren Kondensator 34 bzw. 36 und einem dazu in Serie angeordneten Feldeffekttransistor 35 bzw. 37 bestehen. Die Feldeffekttransistoren 35 und 37 bilden jeweils einen elektronischen Schalter, der den damit verbundenen Kondensator 34 bzw. 36 wahlweise parallel zum Kondensator 32 des Entlastungsnetzwerkes schaltet.

Die Gate-Elektrode des Feldeffekttransistors 35 ist an den Ausgang des Komparators 63 angeschlossen. Die Gate-Elektrode des Feldeffekttransistors 37 liegt am Ausgang des Komparators 66. Die Komparatoren 63 und 66 vergleichen jeweils ein eigenes Referenzsignal U_{Ref1} bzw. U_{Ref2} mit einer Gleichgröße, die dem Ausngangsstrom des Durchflußumrichters proportional ist. Diese Gleichgröße steht als Gleichspannung U_{g} am Ausgang der Abtast- und Halteschaltung 4 zur Verfügung.

Die Abtast- und Halteschaltung 4 bewirkt eine zeitdiskrete Erfassung des pulsförmigen Eingangsstromes I1 über ein aus diskreten Bauteilen zusammengesetztes Abtast- und Halteglied. An die Stelle dieser Anordnung kann gegebenenfalls eine solche mit integriertem Abtast- und Halteglied treten.

Parallel zum Widerstand 415 liegt die aus dem Widerstand 42 und dem Kondensator 43 bestehende Serienschaltung. Der Verbindungspunkt zwischen Widerstand 42 und Kondensator 43 ist über die Source-Drain-Strecke des Feldeffekttransistors 47 an eine Ausgangsklemme der Abtast- und Halteschaltung 4 und von dort über den Widerstand 61 an den nicht invertierenden Eingang des Komparators 63 geführt. Die Gate-Elektrode des Feldeffekttransistors 47 ist über die Parallelschaltung aus Widerstand 46 und Diode 44 an den Ausgang der Steuerschaltung 20 angeschlossen, der mit der Gate-Elektrode des Leistungsschalters 13 verbunden ist. Zwischen dem Gate des Feldeffekttransistors 47 und Bezugspotential liegt der Kondensator 45. Der Feldeffekttransistor 47 ist ferner mit seiner Source-Elektrode über den Kondensator 43 an Bezugspotential und mit seiner Drain-Elektrode über den Kondensator 48 an Bezugspotential geführt.

Die Abtast- und Halteschaltung 4 bewirkt eine zeitdiskrete Erfassung des pulsförmigen Eingangsstromes I1 über ein aus diskreten Bauteilen zusammengesetztes Abtast- und Halteglied. An die Stelle dieser Anordnung kann gegebenenfalls eine solche mit integriertem Abtast- und Halteglied treten.

Durch die Wirkung des RC-Gliedes 45, 46 setzt das Einschalten des Feldeffekttransistors 47 eine vorgegebene Zeitspanne nach dem Einschalten des Leistungstransistors 13 ein. Die Diode 44 ist so gepolt, daß der Kondensator 45 am Ende der Einschaltzeit des Feldeffekttransistors 47 über die Diode 44 entladen und der Feldeffekttransistor unverzögert gesperrt wird.

Auf diese Weise wird der am Ausgang der Abtast- und Halteschaltung 4 liegende Kondensator 48 auf den Scheitelwert der am Widerstand 415 auftretenden Impulsspannung U41 aufgeladen. Gegenüber einem Spitzenwert-Gleichrichter mit Diode ergibt sich ein vergleichsweise geringer Spannungsabfall und störende Stromspitzen beim Einschalten des Leistungstransistors 13 werden unterdrückt.

Der primärseitige Pulsstrom ist in einer durch das Übersetzugnsverhältnis des Transformators 5 vorgegebenen Weise den sekundärseitigen Pulsstrom proportional. Ferner ist der interessierende Mittelwert des Laststromes im eingeschwungenen Zustand gleich dem Mittelwert des sekundärseitigen Pulsstromes. Der Mittelwert dieses Pulsstromes ist bei nicht lückendem Betrieb des Durchflußumrichters, d.h. bei kontinuierlichem Stromfluß durch die Speicherinduktivität 23 gleich dem Spitzenwert, vermindert um die halbe Welligkeit.

Die Abtast- und Halteschaltung 4 liefert daher ein dem Ausgangsstrom des Durchflußumrichters proportionales Gleichsignal.

Eine andere zweckmäßige Möglichkeit für die Gewinnung des dem Ausgangsstrom bzw. der Ausgangsbelastung proportionalen Gleichsignals besteht in einer sekundären Erfassung des Ausgangsstromes über einen Shunt und eine Übertragung des Meßwertes auf die Primärseite mit Hilfe eines Optokopplers. Um dabei auch im Kurzschluß eine Signalübertragung über den Optokoppler sicherzustellen, wird zweckmäßigerweise eine sekundäre Hilfsspannungsversorgung vorgesehen.

Eine weitere zweckmäßige Möglichkeit für die Bildung des Gleichsignals besteht darin, ein Monoflop immer wieder durch den aktuellen, primär oder sekundär erfaßten Pulsstrom zu setzen, so daß am Ausgang des Monoflops das gewünschte Gleichsignal zur Verfügung steht.

Weist der Durchflußumrichter eine Current-Mode-Regelung auf, so ist es zweckmäßig, das vom Spannungsregler am Fototransistor erzeugte Signal zu verwenden.

Auf die Abtast- und Halteschaltung 4 folgen die Steuervorrichtungen 6 und 7. Die Steuervorrichtung 6 enthält den Komparator 63. Bei dem Komparator 63 ist zwischen Ausgang und nicht invertierendem Eingang der Widerstand 64 angeordnet. Am invertierenden Eingang des Komparators 63 liegt die Referenzspannung U_{Ref1}. Der nicht invertierende Eingang des Komparators 63 ist über den Widerstand 61 an den Ausgang der Abtast- und Halteschaltung 4 und über den Kondensator 62 mit Masse verbunden. Der Ausgang des Komparators 63 ist über den Widerstand 65 an die Hilfsspannung U3 gelegt.

Die Steuervorrichtung 7 enthält den Komparator 630. Bei dem Komparator 630 ist zwischen Ausgang und nicht invertierendem Eingang der Widerstand 640 angeordnet. Der nicht invertierende Eingang ist über den Widerstand 610 auch an den Ausgang der Abtast- und Halteschaltung 4 und über den Kondensator 620 mit Masse verbunden. Der Ausgang des Komparators 630 ist über den Widerstand 650 an die Hilfsspannung U3 gelegt.

Am invertierenden Eingang des weiteren Komparators 630 liegt die Referenzspannung U_{Ref2}.

Die Gate-Elektrode des Feldeffekttransistors 37 wird mit Hilfe des weiteren Komparators 630 gesteuert.

Die Komparatoren 63 und 630 sind mit ihren invertierenden Eingängen an verschieden große Referenzspannungen U_{Ref1} und U_{Ref2} und mit ihren nicht invertierenden Eingängen jeweils an ein von der Abtast- und Halteschaltung 4 geliefertes Gleichsignal gelegt. Die Referenzspannungen U_{Ref1} und U_{Ref2} können gegebenenfalls mit Hilfe von Spannungsteilern aus der Referenzspannung eines integrierten Regler-Schaltkreises gewonnen werden.

Die beiden Komparatoren 63 und 630 sprechen bei verschiedenen Werten des impulsförmigen Durchflußwandler-Eingangsstromes I1 an, der ein Maß für den Ausgangsstrom I2 ist. Übersteigt der Eingangsstrom I1 eine erste Schwelle, so spricht der Komparator 63 an und steuert den Feldeffekttransistor 35 leitend. Übersteigt der Eingangsstrom eine zweite Schwelle, so spricht der Komparator 630 an und steuert auch den Feldeffekttransistor 37 leitend. Gegebenenfalls kann der Ausgangsstrom I2 selbst als Meßgröße dienen.

Auf diese Weise wird mit Hilfe der wahlweise anschaltbaren Kondensatoren 34 und 36 der Kondensator 32 des Entlastungsnetzwerkes in Abhängigkeit von der Belastung des Durchflußumrichters modifiziert.

Sind zusätzlich zu den Stromzweigen 34, 35 und 36, 37 weitere derartige Stromzweige vorgesehen, so läßt sich dabei je nach Größe des Eingangsstromes I1 der RCD-Entlastungs-Kondensator 32 durch Zu- oder Abschalten eines oder mehrerer der in den parallelen Stromzweigen enthaltenen Kondensatoren vergrößern oder verkleinern.

Der Durchflußumrichter nach Fig. 1 ermöglicht eine optimale Bemessung der RCD-Beschaltung für hohe Ausgangsströme. Hierdurch ist eine minimale Beanspruchung des Leistungsschalters 13 und eine optimale Ausnutzung des Transformators 5 gegeben. Außerdem ist eine Anpassung der RCD-Beschaltung an den Schwachlastbetrieb durch Verkleinern der Kapazität der RCD-Beschaltung möglich. Hierdurch ergibt sich ein besonders großer Wirkungsgrad des Durchflußumrichters insbesondere auch bei Schwachlast. Außerdem werden Probleme mit der Abmagnetisierung bei minimaler Eingangsspannung und Schwachlast vermieden, da auch in diesem Falle die Spannung am Leistungsschalter 13 genügend schnell aufgebaut wird. Die Hauptinduktivität des Transformators 5 kann vergleichsweise groß gewählt werden, so daß der Magnetisierungsstrom kleiner wird. Dies führt nochmals zu kleineren Kapazitäten und damit nochmals zu kleinerer Verlustleistung.

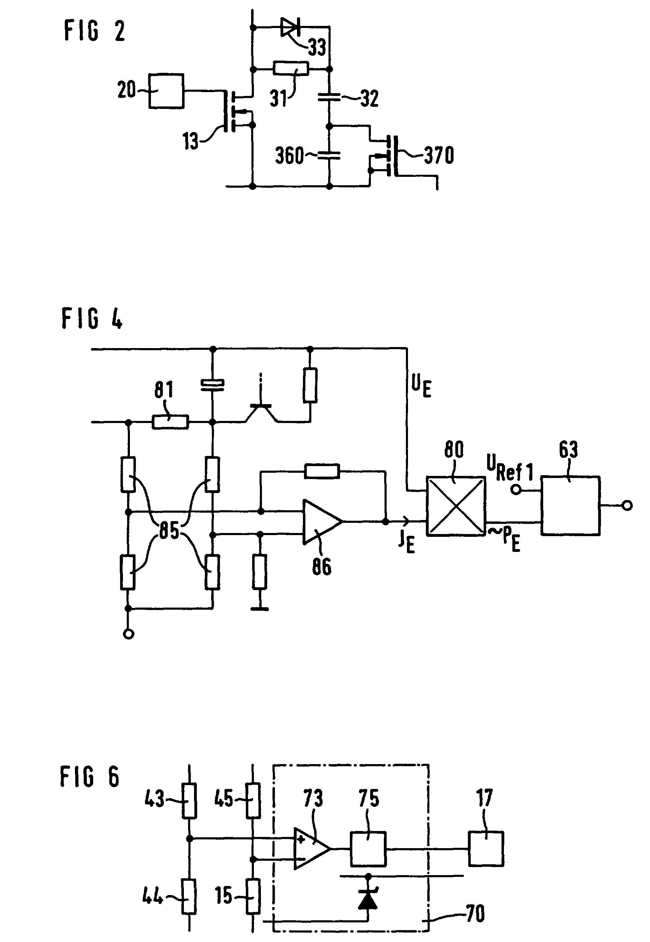

Der in Fig. 2 gezeigte Durchflußumrichter unterscheidet sich von dem nach Fig. 1 dadurch, daß anstelle einer Parallelschaltung mit mehreren Kondensatoren eine Serienschaltung zweier Kondensatoren 32 und 360 liegt, die Drain-Source-Strecke des Feldeffekttransistors 370, mit dessen Hilfe der Kondensator 360 wahlweise wirksam geschaltet oder kurzgeschlossen wird.

Auf diese Weise ist bei dem Durchflußumrichter nach Fig. 2 eine zweistufige Umschaltung der Kapazität des im Entlastungsnetzwerkes 31, 32, 33 enthaltenen Kondensator-Stromzweiges möglich.

Bei den Durchflußumrichtern nach den Figuren 1 und 2 sind die in Serie bzw. parallel zu einem zusätzlichen Kondensator 34, 36, 360 liegenden elektronischen Schalter 35, 37, 370 jeweils durch einen Feldeffekttransistor gebildet. Anstelle dieser Feldeffekttransistoren können andere elektronische Schalter Verwendung finden, insbesondere bipolare Transistoren mit antiparalleler Diode, beliebige Darlington-Schaltungen mit antiparalleler Diode, IGBT mit antiparalleler Diode, hochsperrende Optokoppler, die als Treiber jeweils einen bipolaren oder FET-Transistor ansteuern, Thyristoren mit antiparalleler Diode, Triacs, bei langsamen Laständerungen Relais oder Schütze, Bi-MOS-Kaskoden mit antiparalleler Diode, Kaskoden aus hochsperrendem bipolaren Transistor und niedrig sperrendem Optokoppler oder Bi-MOS-Kaskoden mit antiparalleler Diode in Verbindung mit einem über einen Optokoppler angesteuerten MOS-Transistor.

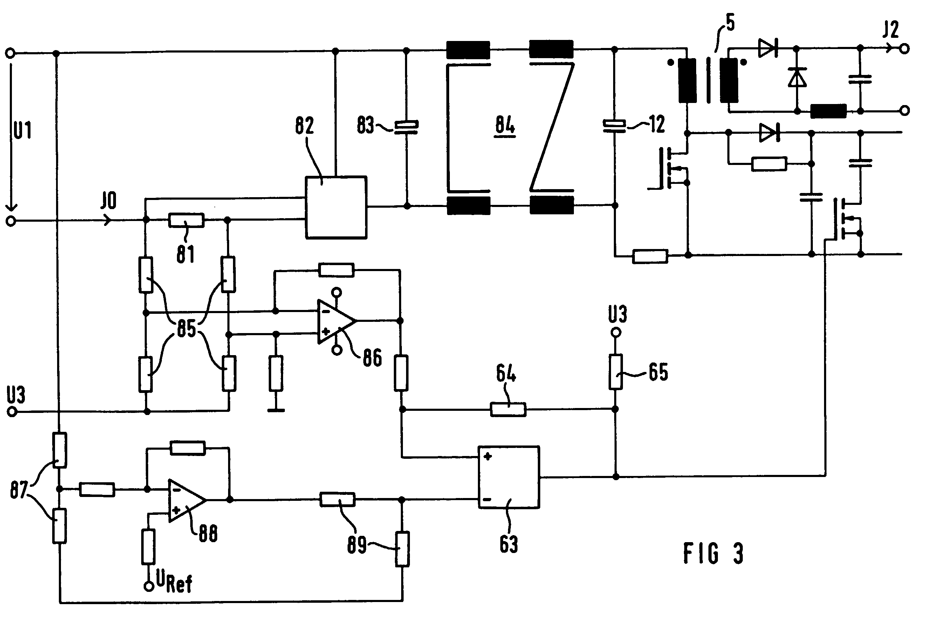

Fig. 3 zeigt für den Durchflußumrichter nach Fig. 1 oder 2 eine Schaltungsanordnung, bei der ein mit der Eingangsspannung gewichteter Mittelwert des Eingangsstromes gebildet wird. Diese Schaltungsanordnung kann gegebenenfalls an die Stelle der Abtast- und Halteschaltung 4 des Durchflußumrichters nach Fig. 1 oder 2 treten.

Der Kondensator 12, der am Eingang eines in Fig. 3 nicht dargestellten und entsprechend Fig. 1 oder 2 aufgebauten Durchflußumrichters liegt, ist über die Filteranordnung 84 an den Kondensator 83 angeschlossen. Der Kondensator 83 wird aus der Eingangsspannungsquelle 11 über den Widerstand 81 und die Vorrichtung 82 zur Begrenzung und/oder Verzögerung des Einschaltstromes gespeist. Eine Vorrichtung zur Verzögerung und Begrenzung des Einschaltstromes ist. z.B. aus der EP-A1 0 272 514 bekannt.

Mit Hilfe des Meßwiderstandes 81 wird der Mittelwert des Eingangsgleichstromes I0 gemessen. Durch Gewichtung mit der Eingangsspannung U1 wird daraus das Ansteuersignal für den Komparator 63 gewonnen. Der für die Vorrichtung 82 sowieso erfaßte Gleichstrom I0 wird zur Festlegung des Schaltzeitpunktes für das Ansprechen des Komparators 63 verwendet. Dieser Gleichstrom I0 ändert sich in Abhängigkeit vom Ausgangsstrom I2 und in Abhängigkeit von der Eingangsspannung U1.

Im Hinblick auf eine veränderbare Eingangsspannung U1 wird die Abhängigkeit des Gleichstroms I0 von der Eingangsspan nung dadurch berücksichtigt, daß der Komparator 63 abhängig von der aufgenommenen Leistung, d.h. von der Eingangsleistung geschaltet wird.

Der Verstärker 86 ist über die Widerstandsbrücke 85 an den Meßwiderstand 81 angeschlossen und verstärkt die relativ kleinen Spannungswerte, die am Strommeßwiderstand 81 auftreten, in Werte, die im Voltbereich liegen. Der Ausgang des Verstärkers 86 ist an den nicht invertierenden Eingang des Komparators 63 geführt.

Der Verstärker 88, dessen invertierendem Eingang über den Spannungsteiler 87 ein Bruchteil der Eingangsspannung zugeführt wird und dessen nicht invertierender Eingang an der Referenzspannung U_{Ref} liegt, invertiert seine Eingangsspannung. Über den Spannungsteiler 89 wird dem invertierenden Eingang des Komparators 63 ein Bruchteil der Ausgangsspannung des Verstärkers 88 zugeführt.

Steigt die Eingangsspannung U1 und sinkt dadurch bedingt der Eingangsstrom I0, so fällt auch die Spannung am invertierenden Eingang des Komparators 63. Der Komparator 63 verharrt somit in seinem Schaltzustand.

Wird dagegen der Eingangsstrom I0 aufgrund einer Änderung des Ausgangsstromes I2 verändert, verändert sich nur die Spannung am nicht invertierenden Eingang des Komparators 63. Daher kann in diesem Fall das Entlastungsnetzwerk des Durchflußumrichters nach Fig. 1 oder 2 mit Hilfe des Komparators 63 umgeschaltet werden.

Ist eine konstante Eingangsspannung U1 sichergestellt, so kann das verstärkte Stromsignal den Komparator 63 abweichend von Fig. 3 direkt ansteuern.

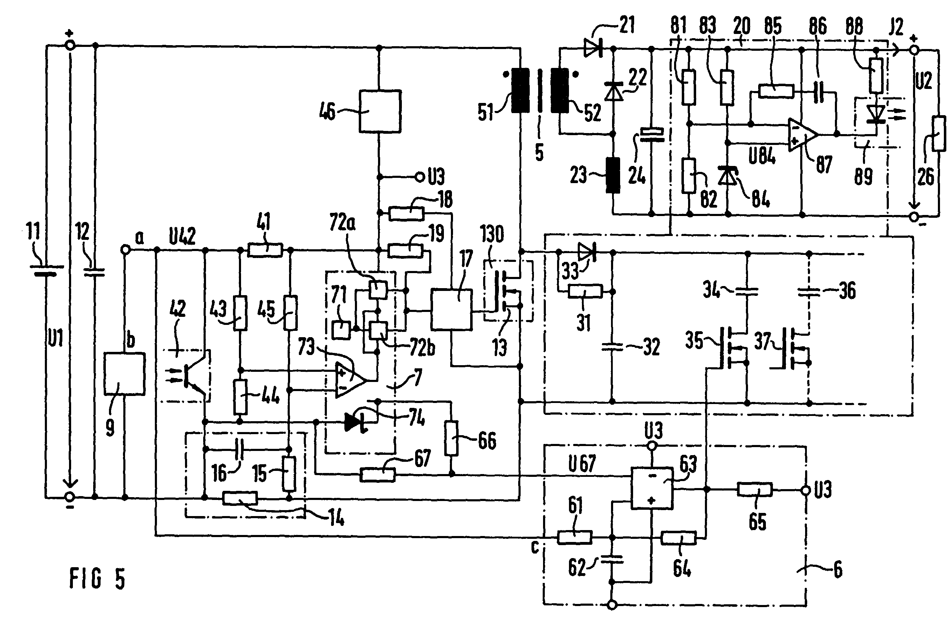

Fig. 4 zeigt in Abwandlung der Schaltungsanordnung nach Fig. 3 eine Anordnung mit Analog-Multiplzierer 80. Der Analog-Multiplizierer 80 bestimmt durch Multiplikation von Eingangsspannung und mittlerem Eingangsstrom I0 die mittlere Eingangsleistung . Der Komparator 63 vergleicht die mittlere Eingangsleistung mit einem Grenzwert und schaltet das Entlastungsnetzwerk gegebenenfalls ein.

Bei dem Eintakt-Durchflußumrichter nach Fig. 5 liegt die von der Gleichspannungsquelle 11 gelieferte Eingangsspannung U1 am Kondensator 12, die Ausgangsspannung U2 am Kondensator 24. Parallel zum Kondensator 12 liegt in einem primärseitigen Wechselstromzwischenkreis eine aus der Primärwicklung 51 des Transformators 5, dem Leistungsschalter 13 und dem Strommeßwiderstand 14 gebildete Serienschaltung.

Als Leistungsschalter 13 dient der Feldeffekttransistor 130, der mit seinem Steuereingang an den Treiber 17 angeschlossen ist. Der Treiber 17 liegt über den Widerstand 18 an der Hilfsspannung U3 und wird von der Steuerschaltung 7 gesteuert.

Die Steuerschaltung 7 enthält den Taktgeber 71, die vom Taktgeber 71 und vom Komparator 73 gesteuerten Impulsdauermodulatoren 72a und 72b sowie die Referenzspannungsquelle 74. Die beiden Impulsdauermodulatoren 72a und 72b bilden eine Vorrichtung zur Impulsdauermodulation, die taktgesteuert eine Folge von impulsdauermodulierten Einschaltimpulsen über den Treiber 17 an den Steuereingang des Leistungsschalters 13 abgibt.

Die Primärwicklung 51 des Transformators 5 wird daher über den Leistungsschalter 13 periodisch an die Eingangsspannungsquelle 11 gelegt.

Zwischen der Sekundärwicklung 52 des Transformators 5 und dem Kondensator 24 liegt die Gleichrichterdiode 21. In einem auf die Gleichrichterdiode 21 folgenden Querzweig ist die Freilaufdiode 22 angeordnet. In einem Längszweig zwischen Freilaufdiode 22 und Kondensator 24 liegt die Drossel 23. Am Kondensator 24 steht die Ausgangsspannung U2 für den einen Verbraucher bildenden Lastwiderstand 25 zur Verfügung. In den Lastwiderstand 25 fließt der Ausgangstrom I20.

Als Fehlerverstärker für die Ausgangsspannung U2 dient der Differenzverstärker 87. Der invertierende Eingang des Differenzverstärkers 87 ist an den Abgriff des aus den Widerständen 81 und 82 bestehenden, parallel zum Ausgang des Durchflußumrichters angeordneten Spannungsteilers 81, 82 angeschlossen. Mit Hilfe der aus dem Widerstand 83 und der Z-Diode 84 bestehenden Serienschaltung wird die Referenzspannung U84 gewonnen, die an den nicht invertierenden Eingang des Differenzverstärkers 87 geführt ist. Zwischen dem Ausgang und dem invertierenden Eingang des Differenzverstärkers 87 liegt die aus dem Widerstand 85 und dem Kondensator 86 bestehende Serienschaltung. Der Ausgang des Differenzverstärkers 87 ist über die aus der Fotodiode 89 und dem Widerstand 88 bestehende Serienschaltung an den Pluspol des Umrichterausgangs geführt. Die Fotodiode 89 ist Bestandteil des Optokopplers 89, 42.

Der zum Optokoppler 89, 42 gehörende Fototransistor 42 liegt mit seinem Emitter am Minuspol des Umrichtereingangs und ist mit seinem Kollektor über den Widerstand 41 an die mit Hilfe des Vorreglers 46 gewonnene Hilfsspannung U3 geführt, die eine konstante Gleichspannung ist. Am Ausgang des Vorreglers 46 liegt somit ein Spannungsteiler, der aus dem Widerstand 41 und der Kollektor-Emitterstrecke des Fototransistors 42 besteht.

Parallel zu dem im primärseitigen Wechselstromzwischenkreis liegenden Widerstand 14 liegt die aus dem Widerstand 15 und dem Kondensator 16 bestehende Serienschaltung. Der Kondensator 16 ist dabei mit dem Minuspol des Umrichtereingangs verbunden. Diese Serienschaltung 15, 16 bildet ein RC-Glied, mit dessen Hilfe die am Widerstand 14 auftretende Meßspannung von störenden Spitzen befreit wird, die jeweils beim Beginn der Einschaltphase des den Leistungsschalter 13 bildenden Feldeffekttransistors 130 entstehen.

Am Verbindungspunkt zwischen Widerstand 15 und Kondensator 16, d.h. am Ausgang des RC-Gliedes 15, 16 liegt der invertierende Eingang des Komparators 73. Der nicht invertierende Eingang des Komparators 73 ist mit dem Abgriff des aus den Widerständen 43 und 44 bestehenden und parallel zur Kollektor-Emitterstrecke des Fototransistors 42 liegenden Spannungsteilers angeschlossen.

Der invertierende Eingang des Komparators 73 ist außerdem über den Widerstand 45 an die Hilfsspannung U3 geführt. Der Widerstand 45 bewirkt eine leichte Anhebung des Potentials am invertierenden Eingang des Komparators 73, z.B. um etwa 100 mV. Hierdurch wird sichergestellt, daß das Potential am nicht invertierenden Eingang des Komparators 73 im Leerlauffall das Potential am invertierenden Eingang des Komparators 73 unterschreiten und die Steuerschaltung 7 zur Begrenzung der Ausgangsspannung Ansteuerimpulse auslassen kann. Der Widerstand 45 kann entfallen, wenn am Ausgang des Durchflußumrichters eine ausreichende Vorlast vorhanden ist.

Der Durchflußumrichter weist somit eine Konstantspannungsregelung mittels unterlagerter Stromregelung, d.h. eine sogenannte Current-Mode-Regelung auf.

Die Referenzspannungsquelle 74 ist einpolig mit dem Minuspol des Umrichtereingangs verbunden. An die Referenzspannungsquelle 74 ist der aus den Widerständen 66 und 67 bestehende Spannungsteiler angeschlossen, an dessen Abgriff die weitere Referenzspannung U67 zur Verfügung steht.

Das aus dem Widerstand 31, dem Kondensator 32 und der Diode 33 bestehende Entlastungsnetzwerk sorgt für eine wirksame Ausschaltentlastung des Leistungsschalters 13. Das Entlastungsnetzwerk enthält eine aus der Diode 33 und dem Kondensator 32 bestehende Serienschaltung, die parallel zur Drain-Source-Strecke des Feldeffekttransistors 130 angeordnet ist. Parallel zur Diode 33 der Serienschaltung liegt der Widerstand 31. Die Diode 33 ist in bezug auf die Eingangsspannung U1 in Durchlaßrichtung gepolt.

Parallel zum Kondensator 32 liegen mehrere Stromzweige, die jeweils aus einem weiteren Kondensator 34 bzw. 36 und einem dazu in Serie angeordneten Feldeffekttransistor 35 bzw. 37 bestehen. Die Feldeffekttransistoren 35 und 37 bilden jeweils einen elektronischen Schalter, der den damit verbundenen Kondensator 34 bzw. 36 wahlweise parallel zum Kondensator 32 des Entlastungsnetzwerkes schaltet.

Die Gate-Elektrode des Feldeffekttransistors 35 ist an den Ausgang des Komparators 63 angeschlossen. Die Gate-Elektrode des Feldeffekttransistors 37 liegt am Ausgang eines nicht dargestellten weiteren Komparators. Der Komparator 63 vergleicht eine eigene Referenzspannung U67 mit der Gleichspannung U42, die ein Maß für den Ausgangsstrom I20 des Durchflußumrichters ist und am Anschluß a zur Verfügung steht.

In vorteilhafter Weise wird dabei das vom Spannungsregler am Fototransistor 42 erzeugte Signal zugleich als Meßgröße für den Ausgangsstrom I2 verwendet.

Zwischen dem Ausgang und dem nicht invertierenden Eingang des Komparators 63 ist der Widerstand 64 angeordnet. Am invertierenden Eingang des Komparators 63 liegt die Referenzspannung U67, die mit Hilfe des an die Referenzspannungsquelle 74 angeschlossenen Spannungsteilers 66, 67 gewonnen wird. Der nicht invertierende Eingang des Komparators 63 ist über den Widerstand 61 an den Anschluß a des Spannungsteilers 41, 42 angeschlossen. Der Ausgang des Komparators 63 ist über den Widerstand 65 an die Hilfsspannung U3 gelegt.

Parallel zur Serienschaltung aus Kondensator 34 und Feldeffekttransistor 35 können die eine Serienschaltung 36, 37 oder mehrere derartige Serienschaltungen vorgesehen sein. Die Gate-Elektrode des Feldeffekttransistors wird dann jeweils mit Hilfe eines eigenen Komparators gesteuert, der an eine eigene Referenzspannung angeschlossen ist, so daß sich eine stufenweise Umschaltung der Kapazität der Entlastungsschaltung ergibt.

Die Komparatoren sind dann zweckmäßigerweise mit ihren invertierenden Eingängen an verschieden große Referenzspannungen und und mit ihren nicht invertierenden Eingängen an dasselbe, vom Anschluß a stammende Gleichsignal gelegt. Die Referenzspannungen können gegebenenfalls mit Hilfe eigener Spannungsteiler aus einer gemeinsamen Referenzspannungsquelle, insbesondere der eines als Steuerschaltung 7 dienenden integrierten Regler-Schaltkreises gewonnen werden.

Die Komparatoren sprechen dann bei verschiedenen Werten des Durchflußwandler-Ausgangsstromes I20 an. Übersteigt der Ausgangsstrom I20 eine erste Schwelle, so spricht der Komparator 63 an und steuert den Feldeffekttransistor 35 leitend. Übersteigt der Ausgangsstrom I20 eine zweite oder weitere Schwelle, so spricht jeweils ein weiterer Komparator an und überführt auch den zugehörigen Feldeffekttransistor 37 in den leitenden Zustand.

Auf diese Weise wird mit Hilfe der durch die Steuervorrichtung 6 wahlweise anschaltbaren Kondensatoren der Kondensator 32 des Entlastungsnetzwerkes in Abhängigkeit von der Belastung des Durchflußumrichters modifiziert.

Der Durchflußumrichter nach Fig. 5 ermöglicht eine optimale Bemessung der RCD-Beschaltung für hohe Ausgangsströme. Hierdurch ist eine minimale Beanspruchung des Leistungsschalters 13 und eine optimale Ausnutzung des Transformators 5 gegeben. Außerdem ist eine Anpassung der RCD-Beschaltung an den Schwachlastbetrieb durch Verkleinern der Kapazität der RCD-Beschaltung möglich. Hierdurch ergibt sich ein besonders großer Wirkungsgrad des Durchflußumrichters insbesondere auch im Schwachlastbetrieb. Außerdem werden Probleme mit der Abmagnetisierung bei minimaler Eingangsspannung und Schwachlast vermieden, da auch in diesem Falle die Spannung am Leistungsschalter 13 genügend schnell aufgebaut wird. Die Hauptinduktivität des Transformators 5 kann vergleichsweise groß gewählt werden, so daß der Magnetisierungsstrom kleiner wird. Dies führt nochmals zu kleineren Kapazitäten und damit nochmals zu kleinerer Verlustleistung.

Die Steuer- und/oder Anzeigevorrichtung 9 liegt zwischen dem Anschluß a und dem Minuspol des Umrichtereingangs. Je nach Anwendungsfall kann es zweckmäßig sein, beide Vorrichtungen 6 und 9 oder eine der beiden Vorrichtungen vorzusehen. Die Vorrichtung 9 kann insbesondere eine Anzeigevorrichtung enthalten, die das Erreichen eines vorgegebenen Grenzwertes des Ausgangsstromes I20 anzeigt. Andererseits kann die Vorrichtung 9 ein Strommeßinstrument zur Anzeige des Ausgangsstromes I20 enthalten.

Die Steuerschaltung 7 kann insbesondere ein Steuer-IC vom Typ TDA 4718 sein.

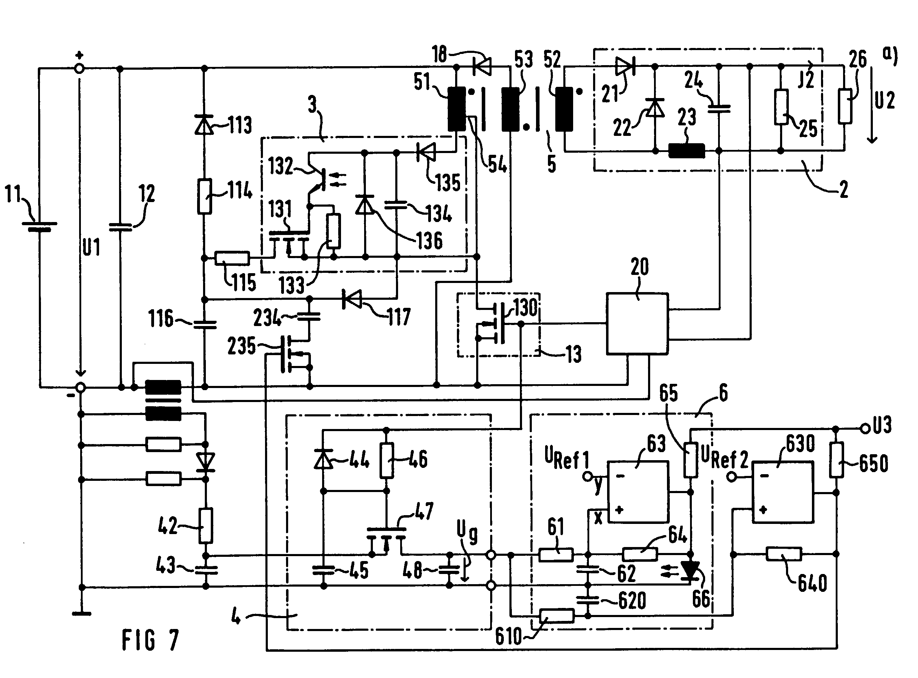

An die Stelle der Steuerschaltung 7 nach Fig. 5 kann die Steuerschaltung 70 nach Fig. 6 treten. Bei dieser Steuerschaltung 70 ist zwischen dem Komparator 72 und dem Treiber 17 das Monoflop 75 vorgesehen, das auf einen Triggerimpuls mit einem Ausgangsimpuls konstanter Dauer antwortet. Auf diese Weise ergibt sich für den Leistungsschalter 13 ein vorgegebener fester Wert für die Zeitabschnitte, in denen er den leitenden Zustand annimmt.

Fig. 7 zeigt einen Eintakt-Durchflußumrichter der weitgehend mit dem nach Fig. 1 übereinstimmt. Abweichend ist eine ausgangsstromabhängige Umschaltung zwischen zwei Entlastungsnetzwerken in Verbindung mit einer Umschaltung der Kapazität des jeweils ausgewählten RCD-Netzwerkes vorgesehen.

Mit Hilfe des Feldeffekttransistors 131 wird in Abhängigkeit von der Belastung des Durchflußumrichters ein von zwei Entlastungsnetzwerken wirksam geschaltet. Ein erstes Entlastungsnetzwerk besteht aus dem Widerstand 115, dem Kondensator 116 und der Diode 117 und sorgt bei großer Belastung des Durchflußumrichters für eine wirksame Ausschaltentlastung des elektronischen Schalters 13. Ein zweites Entlastungsnetzwerk besteht aus der Diode 117, dem Kondensator 116, dem Widerstand 114 und der Diode 113 und bewirkt eine ausreichende Ausschaltentlastung des Leistungsschalters 13 bei kleiner Belastung des Durchflußumrichters.

Beide Entlastungsnetzwerke sind in einer umschaltbaren Gesamtanordnung enthalten. Diese Gesamtanordnung enthält die aus der Diode 117 und dem Kondensator 116 bestehende, parallel zur Drain-Source-Strecke des den Leistungsschalter 13 bildenden Feldeffekttransistors angeordnete Serienschaltung. Parallel zur Diode 117 liegt die aus dem zum Widerstand 115 und der Drain-Source-Strecke des Feldeffekttransistors 131 bestehende Serienschaltung. Dabei ist der Kondensator 116 einpolig mit der Source des den Leistungsschalter 13 bildenden Feldeffekttransistors verbunden. Die Diode 117 ist in bezug auf die Eingangsspannung U1 in Durchlaßrichtung gepolt.

Der Verbindungspunkt von Diode 117 und Kondensator 116 ist über den Widerstand 114 und die dazu in Serie angeordnete und in bezug auf die Eingangsspannung U1 in Sperrichtung gepolte Diode 113 an die Eingangsspannungsquelle 11 geführt.

Der Feldeffekttransistor 131 dient als elektronischer Schalter, mit dessen Hilfe zur Umschaltung von einem der beiden Entlastungsnetzwerke auf das andere der Widerstand 115 wahlweise wirksam oder unwirksam geschaltet wird. Bei Starklast ist der Feldeffekttransistor 131 leitend gesteuert und das erste Entlastungsnetzwerk 115, 116, 117 wirksam. Bei Schwachlast ist der Feldeffekttransistor 131 gesperrt und das zweite Entlastungsnetzwerk 113, 114, 116, 117 wirksam. Bei diesem besteht der Entladestromzweig aus der Serienschaltung von Diode 113 und Widerstand 114, die den Kondensator 116 des Entlastungsnetzwerkes an die Eingangsspannungsquelle 11 legt.

Bei der ersten RCD-Entlastungsschaltung ist der Entladewiderstand 115 der Diode 117 parallel geschaltet, so daß der Kondensator 116 daher völlig entladen wird. Bei dem zweiten Entlastungsnetzwerk bleibt der Kondensator 116 mindestens noch auf die Versorgungsspannung U1 aufgeladen.

Der Feldeffekttransistor 131 wird über einen an die Hilfswicklung 54 des Transformators 5 angeschlossenen Hilfs-Sperrumrichters angesteuert. An der Hilfswicklung 54 liegt die aus der Diode 135 und dem Kondensator 134 bestehende Serienschaltung. Parallel zum Kondensator 134 liegt eine aus der Emitter- Kollektor-Strecke des Optokopplers 132, 66 und dem Widerstand 133 bestehende Serienschaltung und die Z-Diode 136. Der Widerstand 133 liegt parallel zur Gate-Source-Strecke des Feldeffekttransistors 131.

Die Primärwicklung 51 und die Hilfswicklung 54 sind durch eine eine einzige Wicklung mit Anzapfung gebildet. Die Anzapfung, d.h. der Verbindungspunkt der beiden Wicklungen ist mit dem Drain des Feldeffekttransistors 130 und mit der Source des Feldeffekttransistors 131 verbunden.

Bei Schwachlast und daher wirksamem zweiten Entlastungsnetzwerk 113, 114, 116, 117 wird der Transformator 5 nicht mit Hilfe des Entlastungsnetzwerkes ummagnetisiert. Die Ummagnetisierung erfolgt vielmehr mit Hilfe der Entmagnetisierungswicklung 53, die über die in bezug auf die Eingangsspannung U1 in Sperrichtung gepolte Diode 18 an die Eingangsspannungsquelle 11 angeschlossen ist.

Der Durchflußumrichter nach Fig. 7 ermöglicht eine optimale Wahl und Bemessung der RCD-Beschaltung 113 ... 117 für hohe Ausgangsströme. Hierdurch ist eine minimale Beanspruchung des Leistungsschalters 13 gegeben und eine optimale Ausnutzung des Transformators 5 möglich.

Bei vergleichsweise geringem Ausgangsstrom sind die Feldeffekttransistoren 131 und 235 gesperrt. Im RCD-Netzwerk ist der Kondensator 116 wirksam. Der Kondensator 116 wird über den Widerstand 114 auf den Wert der Eingangspannung U1 entladen. Spricht der Komparator 63 an, so wird der Feldeffekttransistor 131 leitend, so daß der Kondensator 116 über den Widerstand 115 entladen werden kann. Bei noch größerem Ausgangsstrom I2 spricht der Komparator 630 an und schaltet über den Feldeffekttransistor 235 den Kondensator 234 parallel zum Kondensator 116.

Andererseits werden besonders geringe Verluste im Kondensator 116 umgesetzt. Außerdem kann auch die durch den Widerstand 25 bewirkte Grundlast vergleichsweise gering gehalten werden, da im Schwachlastbetrieb die Magnetisierungsenergie praktisch vollständig auf den am Eingang des Durchflußumrichters liegenden Kondensator 112 zurückgespeist wird.

## Patentansprüche

1. Durchflußumrichter, in dessen primärseitigen, an eine Eingangsgleichspannungsquelle (11) anschließbaren Hauptstromkreis in Serie zu einer Wicklung (51) eines Transformators (5) ein elektronischer Schalter (13) angeordnet ist und bei dem an wenigstens eine Wicklung (52) des Transformators (5) ein ausgangsseitiger Hauptstromkreis mit einer Gleichrichterdiode (21), einer Freilaufdiode (22) und einer Drossel (23) angeschlossen ist und der parallel zum Schalter (13) ein RCD-Netzwerk (31 ... 33) zur Entlastung des elektronischen Schalters (13) und zur Abmagnetisierung des Transformators (5) aufweist,
**dadurch gekennzeichnet,**
daß der Durchflußumrichter eine Sensoranordnung (41 ... 43, 4) enthält, die als Maß für den Ausgangsstrom eine Gleichgröße (U_{g}) liefert und daß eine an die Sensoranordnung (41 ... 43, 4) angeschlossenen Steuervorrichtung (6) wenigstens einen Komparator (63, 630) enthält, der die Gleichgröße (U_{g}) mit einer Bezugsgröße (U_{Ref1}, U_{Ref2}) vergleicht und daß der Kondensator (32) des RCD-Netzwerks (31 ... 33) durch eine Kondensatoranordnung (32, 34, 36; 32, 340, 360) gebildet ist, die mittels wenigstens eines durch die Steuervorrichtung (6) steuerbaren elektronischen Schalters (35, 37) hinsichtlich ihrer Kapazität variierbar ist.

2. Durchflußumrichter nach Anspruch 1,
**dadurch gekennzeichnet,**
daß die Kondensatoranordnung parallel zu einem Kondensator (32) wenigstens einen Stromzweig mit einem Kondensator (34, 36) und einen in Serie zum Kondensator (34, 36) angeordneten elektronischen Schalter (35, 37) enthält.

3. Durchflußumrichter nach Anspruch 1,
**dadurch gekennzeichnet,**
daß die Kondensatoranordnung in Serie zu einem Kondensator (32) wenigstens einen Stromzweig mit einem Kondensator (340, 360) und einen parallel zum Kondensator (340, 360) angeordneten elektronischen Schalter (Feldeffekttransistor 350, 370) enthält.

4. Durchflußumrichter nach einem der Ansprüche 1 bis 3,
**dadurch gekennzeichnet,**
daß die Sensoranordnung (41 ... 43, 4) eine Abtast- und Halteschaltung (4) enthält, die einen gemeinsam mit dem Leistungsschalter steuerbaren Feldeffekttransistor (47) mit nachfolgendem Speicherkondensator (48) enthält.

5. Durchflußumrichter nach einem der Ansprüche 1 bis 4,
**dadurch gekennzeichnet,**
daß die Sensoranordnung eine Vorrichtung zur Messung der vom Durchflußumrichter aufgenommenen Eingangsleistung durch Gewichtung des Mittelwertes des Eingangsstromes mit der Eingangsspannung enthält.

6. Durchflußumrichter nach einem der Ansprüche 1 bis 5,
**dadurch gekennzeichnet,**
daß bei Regelung der Ausgangsspannung (U2) des Durchflußumrichters mittels einer Spannungsregelung mit unterlagerter Stromregelung, bei der eine Vorrichtung zur Erzeugung eines Fehlersignals aus der Ausgangsspannung ein Fehlersignal ableitet, das mit Hilfe eines Komparators mit einer dem Ausgangsstrom (I2) proportionalen, aus trapezförmigen Impulsen bestehenden Meßspannung verglichen wird, die die Steuervorrichtung (6) steuernde Sensoranordnung durch die Vorrichtung zur Erzeugung des Fehlersignals gebildet ist, und daß das dem Ausgangsstrom proportionale Gleichsignal das vom Spannungsregler am Stromkomparator erzeugte Signal ist.

7. Durchflußumrichter nach einem der Ansprüche 1 bis 6,
**dadurch gekennzeichnet**, daß das parallel zum Leistungsschalter (13) liegende RCD-Netzwerk (15 ... 17) einen Kondensator (16) und eine zum Kondensator (16) in Serie liegende, aus einem Widerstand (15) und einer Diode (17) bestehende Parallelschaltung enthält, und daß der Kondensator (116) des RCD-Netzwerkes (15 ... 17) mit einem seiner Anschlüsse an einen der beiden Pole der Eingangsgleichspannungsquelle (11) geführt ist und mit seinem anderen Anschluß über eine Serienschaltung aus einem Widerstand (114) und einer Diode (113) an den anderen Pol (+) der Eingangsgleichspannungsquelle (11) geführt ist und daß in Serie zum Widerstand (115) des RCD-Netzwerkes ein durch eine Steuervorrichtung (63) steuerbarer elektronischer Schalter (131) angeordnet ist.

## Claims

1. Forward converter in whose primary-side main circuit, which can be connected to a DC supply voltage source (11), an electronic switch (13) is arranged in series with a winding (51) of a transformer (5), and in which there is connected to at least one winding (52) of the transformer (5) a main circuit on the output side having a rectifier diode (21), a freewheeling diode (22) and an inductor (23), and which has in parallel with the switch (13) an RCD network (31 ... 33) for discharging the electronic switch (13) and for demagnetizing the transformer (5), characterized in that the forward converter contains a sensor arrangement (41 ... 43, 4) which supplies a zero-frequency quantity (U_{g}) as a measure of the output current, and in that a control device (6) connected to the sensor arrangement (41 ... 43, 4) contains at least one comparator (63, 630) which compares the zero-frequency quantity (U_{g}) with a reference quantity (U_{Ref1}, R_{Ref2}), and in that the capacitor (32) of the RCD network (31 ... 33) is formed by a capacitor arrangement (32, 34, 36; 32, 340, 360) which can be varied with regard to its capacitance by means of at least one electronic switch (35, 37), which can be controlled by the control device (6).

2. Forward converter according to Claim 1, characterized in that in parallel with one capacitor (32), the capacitor arrangement contains at least one branch circuit with a capacitor (34, 36), and an electronic switch (35, 37) arranged in series with the capacitor (34, 36).

3. Forward converter according to Claim 1, characterized in that in series with one capacitor (32), the capacitor arrangement contains at least one branch circuit with a capacitor (340, 360), and an electronic switch (field-effect transistor 350, 370) arranged in parallel with the capacitor (340, 360).

4. Forward converter according to one of Claims 1 to 3, characterized in that the sensor arrangement (41 ... 43, 4) contains a sample and hold circuit (4) which contains a field-effect transistor (47) which can be controlled in common with the power circuit-breaker and has a downstream storage capacitor (48).

5. Forward converter according to one of Claims 1 to 4, characterized in that the sensor arrangement contains a device for measuring the input power, taken up by the forward converter, by weighting the mean value of the input current with the input voltage.

6. Forward converter according to one of Claims 1 to 5, characterized in that when controlling the output voltage (U2) of the forward converter by means of voltage control with subordinate current control in which a device for generating an error signal derives from the output voltage an error signal which, with the aid of a comparator, is compared with a measuring voltage which is proportional to the output current (I2) and comprises trapezoidal pulses, the sensor arrangement controlling the control device (6) is formed by the device for generating the error signal, and in that the DC signal proportional to the output current is the signal generated by the voltage regulator at the current comparator.

7. Forward converter according to one of Claims 1 to 6, characterized in that the RCD network (15 ... 17) situated in parallel with the power circuit-breaker (13) contains a capacitor (16) and a parallel circuit situated in series with the capacitor (16) and comprising a resistor (15) and a diode (17), and in that the capacitor (116) of the RCD network (15 ... 17) is connected with one of its terminals to one of the two poles of the DC supply voltage source (11) and is connected with its other terminal to the other pole (+) of the DC supply voltage source (11), via a series circuit composed of a resistor (114) and a diode (113), and in that an electronic switch (131) which can be controlled by a control device (63) is arranged in series with the resistor (115) of the RCD network.

## Revendications

1. Convertisseur direct, comportant un circuit principal primaire, qui peut être connecté à une source (11) de tension continue d'entrée et dans lequel est monté en série avec un enroulement (51) d'un transformateur (5) un interrupteur électronique (13), un circuit principal de sortie comportant une diode (21) redresseuse, une diode (22) de roue libre et une bobine (23) étant connecté à au moins un enroulement (52) du transformateur (5) et le convertisseur direct comportant, en parallèle avec l'interrupteur (13) un réseau RCD (31 à 33) pour la décharge de l'interrupteur électronique (13) et pour la démagnétisation du transformateur (5),
caractérisé en ce que
le convertisseur direct comprend un dispositif (41 à 43, 4) de capteur, qui fournit une grandeur (U_{g}) continue comme mesure du courant de sortie et un dispositif (6) de commande connecté au dispositif (41 à 43, 4) de capteur comprend au moins un comparateur (63, 630), qui compare la grandeur continue (U_{g}) à une grandeur (U_{Ref1}, U_{Ref2}) de référence et le condensateur (32) du réseau RCD (31 à 33) est formé d'un dispositif de condensateur (32, 34, 36 ; 32, 340, 360), dont la capacité peut être modifiée au moyen d'au moins un interrupteur (35, 37) électronique pouvant être commandé par le dispositif (6) de commande.

2. Convertisseur direct suivant la revendication 1,
caractérisé en ce que
le dispositif de condensateur comprend en parallèle avec un condensateur (32) au moins une branche de courant, qui comporte un condensateur (34, 36), et un interrupteur électronique (35, 37) disposé en série avec le condensateur (34, 36).

3. Convertisseur direct suivant la revendication 1,
caractérisé en ce que
le dispositif de condensateur comporte en série avec un condensateur (32) au moins une branche de courant, qui comporte un condensateur (340, 360), et un interrupteur électronique (transistor à effet de champ 350, 370) disposé en parallèle avec le condensateur (340, 360).

4. Convertisseur direct suivant l'une des revendications 1 à 3,
caractérisé en ce que
le dispositif (41 à 43, 4) de capteur comprend un circuit (4) d'échantillonnage et de blocage, qui comprend un transistor (47) à effet de champ, qui peut être commandé en commun avec l'interrupteur de puissance et en aval duquel se trouve un condensateur (48) d'accumulation.

5. Convertisseur direct suivant l'une des revendications 1 à 4,
caractérisé en ce que
le dispositif de capteur comprend un dispositif de mesure de la puissance d'entrée reçue par le convertisseur direct par pondération de la valeur moyenne du courant d'entrée par la tension d'entrée.

6. Convertisseur direct suivant l'une des revendications 1 à 5,
caractérisé en ce que
lors du réglage de la tension (U2) de sortie du convertisseur direct au moyen d'une régulation de tension à régulation de courant en cascade, dans laquelle un dispositif de production d'un signal d'erreur obtient à partir de la tension de sortie un signal d'erreur, qui est comparé à l'aide d'un comparateur à une tension de mesure proportionnelle au courant (I2) de sortie et constituée d'impulsions trapézoïdales, le dispositif de capteur commandant le dispositif (6) de commande est formé par le dispositif de production du signal d'erreur et le signal continu proportionnel au courant de sortie est le signal produit par le régulateur de tension dans le comparateur de courant.

7. Convertisseur direct suivant l'une des revendications 1 à 6,
caractérisé en ce que le réseau RCD (15 à 17) se trouvant en parallèle avec l'interrupteur (13) de puissance comprend un condensateur (16) et un circuit parallèle se trouvant en série avec le condensateur (16) et constitué d'une résistance (15) et d'une diode (17), le condensateur (116) du réseau RCD (15 à 17) est relié, par une de ses bornes, à l'un des deux pôles de la source (11) de tension continue d'entrée et est relié, par son autre borne, par l'intermédiaire d'un circuit-série constitué d'une résistance (114) et d'une diode (113) à l'autre pôle (+) de la source (11) de tension continue d'entrée et un interrupteur (131) électronique pouvant être commandé par un dispositif (63) de commande est disposé en série avec la résistance (115) du réseau RCD.
